# EUROPÄISCHE PATENTSCHRIFT

(11) **EP 2 783 433 B1**
(45) Veröffentlichungstag und Bekanntmachung des Hinweises auf die Patenterteilung: **01.08.2018**
(21) Anmeldenummer: 12818875.2
(22) Anmeldetag: 22.11.2012
(51) Int. Cl.: H01R 13/6587, H01R 12/58, H01R 12/52, H01R 12/70, H01R 12/73, H05K 3/36

(54) **STECKVERBINDER MIT ABSCHIRMUNG**
CONNECTOR WITH SHIELD
CONNECTEUR AVEC BLINDAGE

(30) Priorität: 24.11.2011 DE 102011119274
(43) Veröffentlichungstag der Anmeldung: 01.10.2014
(73) Patentinhaber: ERNI Production GmbH & Co. KG, 73099 Adelberg (DE)
(72) Erfinder: LAPPÖHN, Jürgen, 73108 Gammelshausen (DE)
(74) Vertreter: Jakelski & Althoff Patentanwälte PartG mbB
(86) Internationale Anmeldenummer: PCT/DE2012/001111
(87) Internationale Veröffentlichungsnummer: WO 2013/075693

(56) Entgegenhaltungen:
- EP-A1- 2 099 098
- US-A1- 2003 008 561
- US-A1- 2003 143 894
- US-A1- 2006 024 983
- US-A1- 2008 205 822

## Beschreibung

Die vorliegende Erfindung betrifft einen Steckverbinder mit Abschirmung, der Signalkontakte aufweist. Weiterhin betrifft die Erfindung eine elektronische Anordnung, welche zwei erfindungsgemäße Steckverbinder aufweist, die auf zwei gegenüberliegenden Seiten einer Leiterplatte angeordnet sind.

### Stand der Technik

Steckverbinder mit Abschirmung sind beispielsweise aus der EP 1 470 618 B1 bekannt geworden. In der Elektronikindustrie kommen sehr oft Steckverbindungen für eine elektrische Verbindung zwischen zwei Leiterplatten, beispielsweise einer sogenannten Backplane, und an ihr befestigten Leiterplatten oder auch zwischen Leiterplatten und Verbindungsleitungen, zum Einsatz. Dabei wird beispielsweise eine Messerleiste auf einer ersten Leiterplatte angeordnet und eine an sie angepasste Federleiste auf einer weiteren Leiterplatte. Diese weitere Leiterplatte wird dann mit Hilfe der Federleiste der Steckverbindung an der ersten Leiterplatte befestigt und elektrisch kontaktiert.

Die Übertragungsfrequenz von über diese Steckverbinder übertragenen elektrischen Signalen kann sehr hoch sein. Dabei ist nicht nur eine ausgeglichene Impedanz der verschiedenen Kontakte innerhalb der Kontaktleiste erforderlich, um Signalverzögerungen und -reflexionen zu verringern, sondern auch eine Abschirmung der Differentialkontakte. Diese wird durch eine L-förmige Abschirmung realisiert, wie sie aus der EP 1 470 618 B1 hervorgeht.

Um eine optimale Datenübertragungsrate zu erreichen, sieht die EP 1 470 618 B1 eine Steckerleiste mit Signalkontakten vor, die in einem Kontaktmuster von Differentialpaaren angeordnet sind, die in Reihen und Spalten ausgerichtet sind, wobei jedes Differentialpaar zwei der Signalkontakte umfasst, die um einen ersten Abstand beabstandet sind; eine Erdungsabschirmung mit einem jeden Differentialpaar verbunden ist, wobei jede Erdungsabschirmung einen Messerabschnitt umfasst, der sich entlang einer Seite der beiden Signalkontakte in ihrem dazugehörenden Paar erstreckt, und wobei jede Erdungsabschirmung einen Schenkelabschnitt umfasst, der sich entlang eines Endes eines dazugehörenden Differentialpaares erstreckt; und wobei benachbarte der Differentialpaare um einen zweiten Abstand beabstandet sind, der größer ist als der erste Abstand.

Aus der DE 10 2009 010 487 A1 ist ein Steckverbinder bekannt, der hohe Datenübertragungsraten ermöglicht. Dieser hat weiterhin den Vorteil, dass er nicht den filigranen Aufbau des zuvor beschriebenen Steckverbinders aufweist, der in vielen Fällen nicht die nötige Stabilität aufweist, um ein mehrfaches Stecken und wieder Lösen der beiden Steckverbindungselemente, nämlich Messer- und Federleiste, ohne Weiteres zu ermöglichen.

Allerdings führt die Anordnung der Differentialpaare in den bekannten Steckverbindern dazu, dass zwei Steckverbinder, die auf unterschiedlichen Seiten einer Leiterplatte angeordnet werden sollen und deren einander entsprechende Kontaktelemente gleichzeitig elektrisch leitend miteinander verbunden sind, nur so auf der Leiterplatte befestigt werden können, dass der zweite Steckverbinder spiegelbildlich zum ersten Steckverbinder angeordnet ist, oder gegenüber diesem um 180° gedreht ist. Wenn jedoch Leiterplatten auf zwei Seiten einer Backplane zueinander um 90° gedreht angeordnet werden sollen, ist es hierzu wünschenswert, zwei Steckverbinder auf unterschiedlichen Seiten der Backplane um 90° zueinander gedreht anordnen zu können.

Die US 2006/0024983 A1 betrifft eine elektrische Steckverbindung, die Differentialpaare enthält, die in Reihen angeordnet sind. Jedes die Differentialpaar umfasst zwei Signalkontakte, wobei jeder dieser Signalkontakte zwei Enden hat, wobei ein erstes Ende mit der Leiterplatte verbunden werden kann. Die jeweils ersten Enden jedes Differentialpaars liegen auf gemeinsamen Linien, die parallel zur Reihe sind. Des Weiteren umfasst die Steckverbindung für jedes Differentialpaar eine Abschirmung, die ebenfalls auf einer gemeinsamen Linie liegen, die parallel zur Reihe ist. Durch die Anordnung ist der Abstand der Mittelpunkte der Signalkontaktelemente benachbarter Differentialpaare unterschiedlich zu einem Abstand zwischen zwei benachbarten Abschirmkontaktelementen.

Die EP 2 099 098 A1 betrifft ebenfalls eine elektrische Steckverbindung, die Signalkontakte enthält, welche als Differentialpaare angeordnet sind. Diese sind in Reihen und Spalten angeordnet. Sie umfassen einen Körper, einen Signalkontaktpin und ein Signalkontaktende, die sich jeweils auf verschiedenen Seiten des Körpers erstrecken. Die Signalkontaktpins sind um in eine seitliche Richtung A im Vergleich zur Kontaktebene verschoben. Die Signalkontaktenden sind in der Kontaktebene angeordnet und um eine Querrichtung B im Vergleich zu Pinachsen verschoben. Zudem umfasst die Steckverbindung Abschirmkontaktelemente, die ähnlich wie die Signalkontakte, außermittig angeordnete Abschirmkontaktpins umfasst. Dadurch kann jedes Signalkontaktpin und jedes Abschirmkontaktpin mittig in den Reihen und Spalten sitzen. Dies hat zur Folge, dass die Signalkontakte nicht auf einer gemeinsamen Geraden liegen.

Die US 2008/0205822 A1 betrifft einen elektrisch leitfähigen Kontakt für eine elektrische Steckverbindung. Dieser umfasst ein Leitungsstück ein Versatzstück und ein Befestigungsstück. Diese sind so angeordnet, dass das Leitungsstück, einerseits, einen Abstand zum Befestigungsstück hat, andererseits um einen Winkel gedreht ist. Außerdem betrifft das Dokument eine elektrische Steckverbindung, die zwei solche Kontakte (Signalkontakte) enthält. Diese sind als Differentialpaar ausgebildet. Des Weiteren enthält die Steckverbindung Abschirmelemente und die Differentialpaare und Abschirmelemente sind in Reihen und Spalten angeordnet und liegen auf einer gemeinsamen Geraden. Die Abschirmkontakte haben hierbei eine gerade Form, dementsprechend keine L-Form oder C-Form.

In der US 2003/0143894 betrifft eine Steckverbinderanordnung, die eine Steckerleiste mit Signalkontakten aufweist, die in einem Kontaktmuster von Differentialpaaren angeordnet sind, die in Reihen und Spaltenausgerichtet sind. Jedes Differentialpaar umfasst zwei der Signalkontakte, die um einen ersten Abstand beabstandet sind. Eine L-förmige Erdungsabschirmung ist mit einem jeden Differentialpaar verbunden ist. Benachbarte Differentialpaare sind um einen zweiten Abstand beabstandet, der größer ist als der erste Abstand ist.

Die US 2003/0008561 A1 betrifft einen Steckverbinder mit Kröpfung. Dieser besteht aus einer Messer- und einer Federleiste mit mindestens sechs Kontaktelementen die durch C-förmige Abschirmbleche nach außen und gegen weitere Kontaktelemente abgeschirmt sind. Die Kontaktelemente sind in den Messer- und Federleisten in mehreren parallelen Reihen sowie miteinander fluchtend angeordnet. Die Abschirmbleche umgreifen jeweils zwei benachbarte Kontaktelemente aus zwei benachbarten Reihen.

### Offenbarung der Erfindung

Der erfindungsgemäße Steckverbinder umfasst eine Abschirmung und Signalkontakte, welche in einem Kontaktmuster von Differentialpaaren angeordnet sind und zusammen mit einem sie umgebenden Abschirmkontakte eine Kontaktgruppe bilden. Die Kontaktgruppen sind in Reihen und Spalten angeordnet. Jeder Abschirmkontakt weist ein Abschirmelement und mindestens ein Abschirmkontaktelement auf. Jeder Signalkontakt weist ein Messerelement und ein Signalkontaktelement auf. Alle Abschirmkontaktelemente innerhalb einer Reihe liegen auf einer gemeinsamen Geraden. Die Signalkontaktelemente jedes Differentialpaares liegen jeweils auf einer Geraden, die einen Winkel von 45° mit der gemeinsamen Geraden der Abschirmkontaktelemente innerhalb der Reihe bildet.

Insbesondere liegen auch alle Abschirmkontaktelemente innerhalb einer Spalte auf einer gemeinsamen Geraden und die Signalkontaktelemente jedes Differentialpaares liegen jeweils auf einer Geraden, die einen Winkel von 45° mit der gemeinsamen Geraden der Abschirmkontaktelemente innerhalb der Spalte bildet. Außerdem liegen insbesondere alle Messerelemente innerhalb einer Spalte auf einer gemeinsamen Geraden.

In jeder Reihe und in jeder Spalte entspricht ein Abstand zwischen dem Mittelpunkt der beiden Signalkontaktelemente eines Differentialpaares und dem Mittelpunkt der Signalkontaktelemente eines benachbarten Differentialpaares im Wesentlichen dem Abstand zwischen zwei benachbarten Abschirmkontaktelementen. Unter dem Mittelpunkt wird erfindungsgemäß der Punkt verstanden, welcher auf einer Verbindungsgeraden zwischen den beiden Signalkontaktelementen eines Differentialpaares auf halber Strecke zwischen diesen beiden Signalkontaktelementen liegt. Unter benachbart werden zwei Differentialpaare bzw. Abschirmkontaktelemente verstanden, die innerhalb einer Reihe oder innerhalb einer Spalte unmittelbar aufeinander folgen.

Die Abschirmelemente sind L-förmig ausgeführt, um eine möglichst platzsparende Abschirmung der differenziellen Paare zu realisieren. Da hierbei jedoch das jeweils letzte Differentialpaar einer Reihe bzw. einer Spalte zum Rand des Steckverbinders hin nicht abgeschirmt wird, ist in jeder Spalte ein Abschirmelement C-förmig ausgeführt. Der zusätzliche Schenkel des C sorgt im Vergleich zum L für eine Abschirmung des letzten differenziellen Paares zum Rand des Steckverbinders hin.

Jeder Abschirmkontakt mit L-förmigem Abschirmelement weist vorzugsweise nur ein Abschirmkontaktelement auf, um die erfindungsgemäße Anordnung von Abschirmkontaktelementen und Signalkontaktelementen zu ermöglichen. Jeder Abschirmkontakt mit C-förmigem Abschirmelement weist bevorzugt zwei Abschirmkontaktelemente auf, um eine sichere Befestigung des C-förmigen Abschirmelements im Steckverbinder zu gewährleisten.

Die erfindungsgemäße Anordnung von Messerelementen und Signalkontaktelementen kann erfindungsgemäß durch eine spezielle Ausgestaltung der Signalelemente realisiert werden. Hierbei ist es bevorzugt, dass das Messerelement und das Signalkontaktelement jedes Signalelements parallel zueinander angeordnet sind und mit einem Verbindungselement miteinander verbunden sind. Insbesondere ist das Verbindungselement im Wesentlichen stabförmig ausgeführt und bildet einen Winkel von 90° sowohl mit dem Messerelement als auch mit dem Signalkontaktelement.

Der Abstand zwischen den beiden Signalkontaktelementen jedes Differentialpaares entspricht erfindungsgemäß im Wesentlichen dem Abstand zwischen den beiden Messerelementen.

Die erfindungsgemäßen Steckverbinder können zum Realisieren einer Anordnung verwendet werden, die je zwei Steckverbinder und eine Leiterplatte umfasst. Die Signalkontaktelemente und Abschirmkontaktelemente des ersten Steckverbinders sind dabei auf einer Seite der Leiterplatte angeordnet und die Signalkontaktelemente und Abschirmkontaktelemente des zweiten Steckverbinders sind auf der anderen Seite der Leiterplatte angeordnet. Hierbei sind die Signalkontaktelemente des ersten Steckverbinders mit den Signalkontaktelementen des zweiten Steckverbinders verbunden und der erste Steckverbinder ist in einem Winkel von 90° zu dem zweiten Steckverbinder gedreht. Da die Leiterplatte als Backplane fungiert, ermöglicht es diese Anordnung von zwei erfindungsgemäßen Steckverbindern zwei weitere Leiterplatten, die auf den beiden gegenüberliegenden Seiten der Backplane angeordnet sind, in einem Winkel von 90° miteinander über die Backplane zu verbinden.

### Kurze Beschreibung der Zeichnungen

Ein Ausführungsbeispiel der Erfindung ist in den Zeichnungen dargestellt und in der nachfolgenden Beschreibung näher erläutert.
Fig. 1 ist eine Aufsicht auf eine Rückseite eines Steckverbinders gemäß dem Stand der Technik.
Fig. 2 ist eine Aufsicht auf eine Vorderseite eines Steckverbinders gemäß dem Stand der Technik.
Fig. 3 ist ein Detailausschnitt aus Fig. 2.
Fig. 4 ist eine isometrische Darstellung eines Differentialpaares eines Steckverbinders gemäß dem Stand der Technik.
Fig. 5 ist eine Ansicht von unten eines Differentialpaares eines Steckverbinders gemäß dem Stand der Technik.
Fig. 6 ist eine Aufsicht auf eine Rückseite eines Steckverbinders gemäß einer Ausführungsform der Erfindung.
Fig. 7 ist eine Aufsicht auf eine Vorderseite eines Steckverbinders gemäß einer Ausführungsform der Erfindung.
Fig. 8 ist ein Detailausschnitt aus Fig. 7.
Fig. 9 ist eine isometrische Darstellung eines Differentialpaares eines Steckverbinders gemäß einer Ausführungsform der Erfindung.
Fig. 10 ist eine Ansicht von unten eines Differentialpaares eines Steckverbinders gemäß einer Ausführungsform der Erfindung.
Fig. 11 zeigt die Anordnung von zwei um 90° zueinander gedrehten Steckverbindern gemäß einer Ausführungsform der Erfindung in isometrischer Darstellung.
Fig. 12 zeigt die um 90° gedrehte Anordnung mehrerer Leiterplatten beidseitig einer Backplane mit Hilfe erfindungsgemäßer Steckverbinder.

### Ausführungsbeispiele der Erfindung

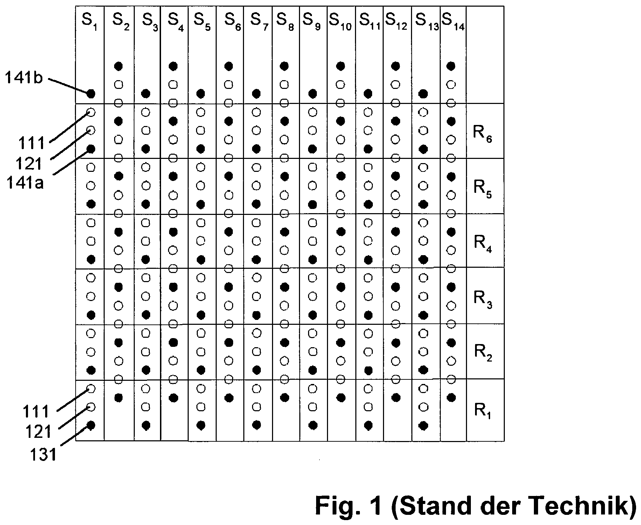

In den Fig. 1 bis 5 ist ein herkömmlicher Steckverbinder dargestellt, wie er beispielsweise aus der DE 10 2009 040 482 A1 bekannt ist. In Fig. 1 ist die Rückseite eines solchen Steckverbinders dargestellt. Unter Rückseite eines Steckverbinders wird im Folgenden jene Seite verstanden, auf welcher Abschirmkontaktelemente und Signalkontaktelemente angeordnet sind (Platinenseite). Die Signalkontaktelemente 111, 121 und die Abschirmkontaktelemente 131 sind in Reihen R₁ bis R₆ und in Spalten S₁ bis S₁₄ angeordnet. In jeder Spalte folgt auf zwei Signalkontaktelemente 111, 121 jeweils ein Abschirmkontaktelement 131. Jeweils zwei innerhalb einer Spalte aufeinanderfolgende Signalkontaktelemente 111, 121 bilden zusammen ein Differentialpaar. Die Spalten sind zueinander versetzt angeordnet, sodass innerhalb jeder Reihe jeweils ein Differentialpaar zwischen zwei Abschirmkontaktelementen 131 angeordnet ist, wobei jedes Signalkontaktelement 111, 121 jedes Differentialpaares jeweils denselben Abstand zu den beiden benachbarten Abschirmkontaktelementen 131 aufweist. Es ist ersichtlich, dass zwei derartige Steckverbinder nicht so um 90° zueinander gedreht auf zwei gegenüberliegenden Seiten einer Leiterplatte angeordnet werden können, dass korrespondierende Signalkontaktelemente 111, 121 miteinander verbunden sind. Zwar würden bei einer Drehung der beiden Steckverbinder um 90° zueinander die Abschirmkontaktelemente 131 deckungsgleich aufeinander zu liegen kommen, jedoch wäre keine Kontaktierung der Signalkontaktelemente 111, 121 möglich.

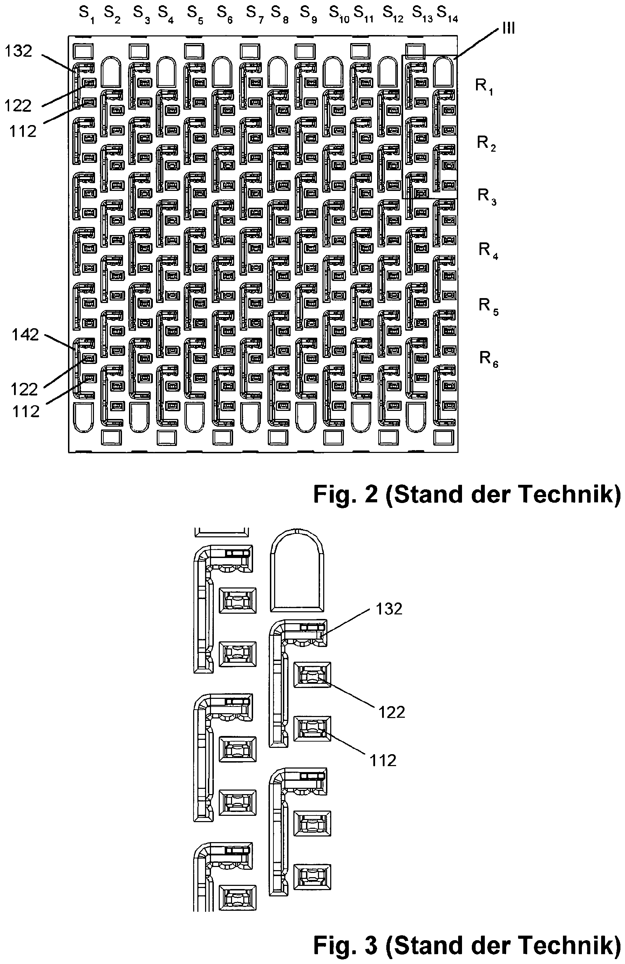

Fig. 2 zeigt die Vorderseite des bekannten Steckverbinders. Unter Vorderseite eines Steckverbinders wird im Folgenden jene Seite verstanden, auf welcher die Messerelemente und die Abschirmelemente angeordnet sind (Steckerseite). Auch die Messerelemente 112, 122 und die Abschirmelemente 132 des bekannten Steckverbinders sind in Reihen R₁ bis R₆ und in Spalten S₁ bis S₁₄ angeordnet. In jeder Spalte werden die beiden Messerelemente 112, 122 eines Differentialpaares an zwei Seiten von einem L-förmigen Abschirmelement 132 umgeben. Ein auf dieses Abschirmelement 132 folgendes Abschirmelement schirmt die dritte Seite des Differentialpaares innerhalb jeder Spalte ab. An der Grenze zu einer benachbarten Spalte erfolgt eine Abschirmung des Differentialpaares durch zwei Abschirmelemente 132 der benachbarten Spalte. Dies wird dadurch erreicht, dass sich der Versatz zwischen den jeweils benachbarten Spalten, welcher in Fig. 1 für die Signalkontaktelemente 111, 121 und die Abschirmkontaktelemente 131 beschrieben wurde, auch auf der Vorderseite des Steckverbinders für die Messerelemente 112, 122 und die Abschirmelemente 132 fortsetzt. Am Ende jeder Spalte ist ein L-förmiges Abschirmelement 132 durch ein C-förmiges Abschirmkontaktelement 142 ersetzt, um eine Abschirmung zum Spaltenende hin zu gewährleisten. Das C-förmige Abschirmelement 142 weist zwei Abschirmkontaktelemente 142a, 142b auf. Ein Detailausschnitt der Reihen R₁ und R₂ in den Spalten S₁₃ und S₁₄ in Figur 2 (dort mit dem Bezugszeichen III gekennzeichnet) ist in Figur 3 gezeigt.

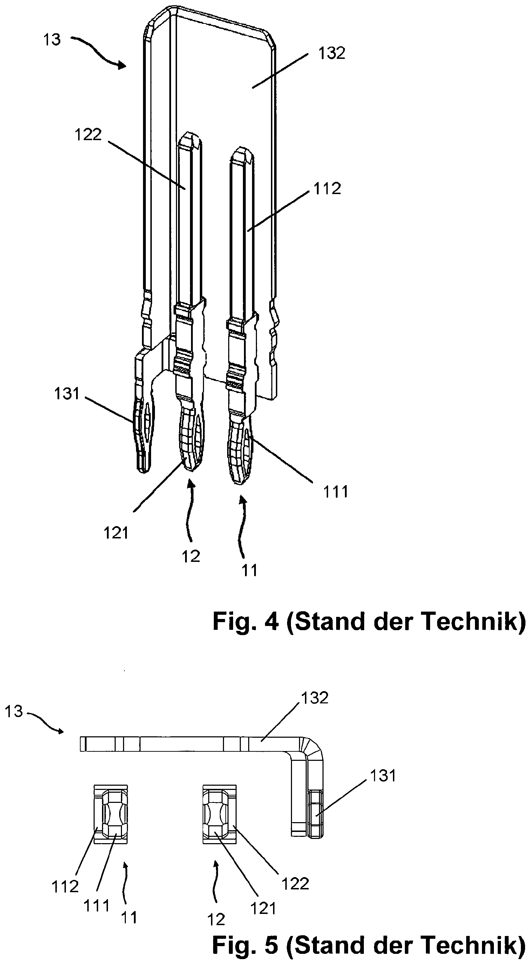

Eine isometrische Ansicht eines Differentialpaares aus zwei Signalkontakten 11, 12 und ihrem zugehörigen Abschirmkontakt 13 ist in Fig. 4 dargestellt. Eine Ansicht eines Differentialpaares und dessen zugehörigem Abschirmkontakt 13 von unten, d. h. aus der Richtung der Signalkontaktelemente 111, 121 und des Abschirmkontaktelementes 131 findet sich in Fig. 5. Eine Aufsicht auf ein Differentialpaar aus zwei Messerelementen 112, 122 und dem dazugehörigen Abschirmelement 132 ist in Fig. 4 dargestellt. Hierbei ist zu erkennen, dass das Abschirmelement 132 in derselben Spalte, in der die Messerelemente 112, 122 angeordnet sind, in sein Abschirmkontaktelement 131 übergeht.

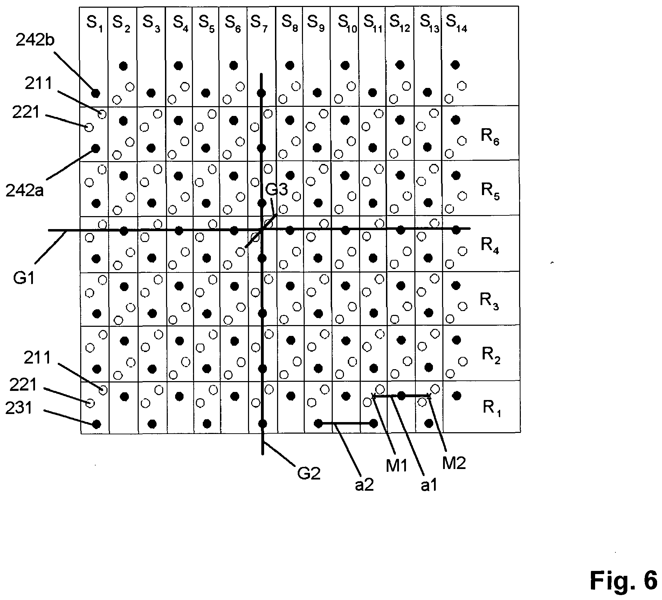

In den Fig. 6 bis 10 ist eine Ausführungsform eines erfindungsgemäßen Steckverbinders dargestellt. Fig. 6 zeigt die Rückseite des erfindungsgemäßen Steckverbinders. Alle Signalkontaktelemente 211, 221 und alle Abschirmkontaktelemente 231 sind in Reihen R₁ bis R₆ und in Spalten S₁ bis S₁₄ angeordnet. Alle Abschirmkontaktelemente 231 innerhalb einer Reihe liegen auf einer gemeinsamen Geraden G1. Alle Abschirmkontaktelemente 231 innerhalb einer Spalte S liegen auf einer gemeinsamen Geraden G2. Die Signalkontaktelemente 211, 221 jedes Differentialpaares liegen jeweils auf einer Geraden G3, die einen Winkel von 45° mit der gemeinsamen Geraden G1 der Abschirmkontaktelemente 231 innerhalb der Reihe bildet und die außerdem einen Winkel von 45° mit der gemeinsamen Geraden G2 der Abschirmkontaktelemente 231 innerhalb der Spalte bildet. Dies ist in Figur 6 exemplarisch für die Spalte S₇ und die Reihe R₄ gezeigt. Es ist erkennbar, dass diese Anordnung der Signalkontaktelemente 211, 221 und Abschirmkontaktelemente 231 eine vierzählige Drehspiegelachse (S4-Symmetrieachse) aufweist, welche senkrecht auf der gemeinsamen Ebene der Signalkontaktelemente 211, 221 und Abschirmkontaktelemente 231 steht. Dies ermöglicht es, zwei erfindungsgemäße Steckverbinder auf zwei gegenüberliegenden Seiten einer Leiterplatte um 90° zueinander gedreht anzuordnen, wobei miteinander korrespondierende Signalkontaktelemente 211, 221 beider Steckverbinder jeweils aufeinander zu liegen kommen und die Abschirmkontaktelemente 231 beider Steckverbinder ebenfalls jeweils aufeinander zu liegen kommen und so unmittelbar und insbesondere ohne zusätzliche Leiterbahnen, Verbindungsleitungen und dergleichen kontaktiert werden können.

In jeder Reihe und in jeder Spalte entspricht ein Abstand a1 zwischen dem Mittelpunkt M1 der beiden Signalkontaktelemente 211, 221 eines Differentialpaares und dem Mittelpunkt M2 der Signalkontaktelemente 211, 221 eines benachbarten Differentialpaares im Wesentlichen dem Abstand a2 zwischen zwei benachbarten Abschirmkontaktelementen 231.

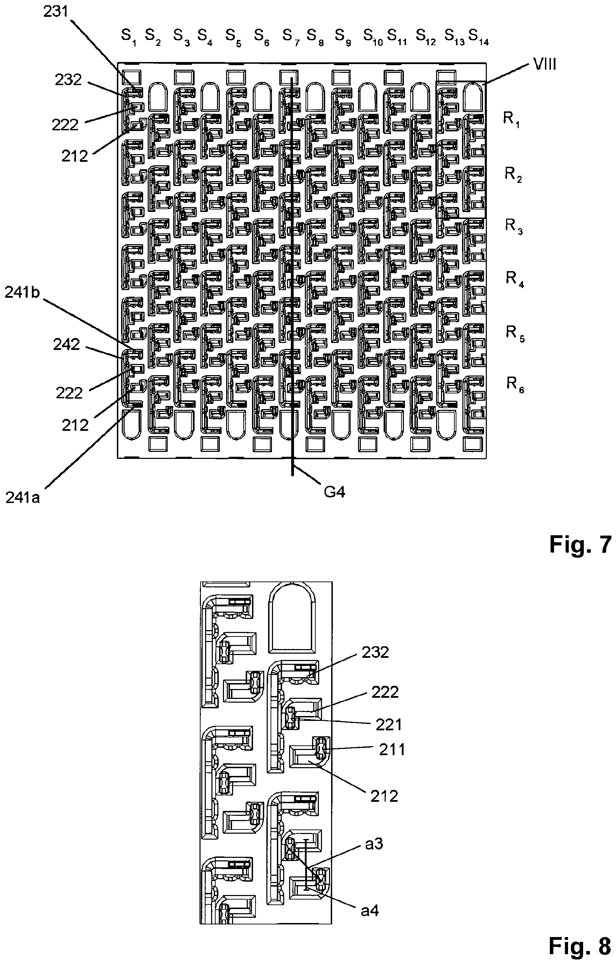

Fig. 7 zeigt eine Aufsicht auf die Vorderseite des erfindungsgemäßen Steckverbinders. Ein Detailausschnitt der Reihen R₁ und R₂ in den Spalten S₁₃ und S₁₄ in Figur 7 (dort mit dem Bezugszeichen VIII gekennzeichnet) ist in Figur 8 gezeigt. Auch die Messerelemente 212, 222 und die Abschirmelemente 232 des bekannten Steckverbinders sind in Reihen R₁ bis R₆ und in Spalten S₁ bis S₁₄ angeordnet. Die Abschirmelemente 231 sind L-förmig, wobei am Ende jeder Spalte ein L-förmiges Abschirmelement 232 durch ein C-förmiges Abschirmkontaktelement 242 ersetzt ist, welches zwei Abschirmkontaktelemente 242a, 242b aufweist. Hierdurch wird eine Abschirmung der Differentialpaare aus jeweils zwei Messerelementen 212, 222 in derselben Weise bewirkt wie in dem Steckverbinder gemäß Figur 2. Alle Messerelemente 212, 222 und alle Abschirmkontaktelemente 231 innerhalb einer Spalte liegen auf einer gemeinsamen Geraden G4. Dies ist in Figur 7 exemplarisch für die Spalte S₇ gezeigt. Der Abstand a3 zwischen den beiden Signalkontaktelementen 211, 221 jedes Differentialpaares entspricht im Wesentlichen dem Abstand a4 zwischen den beiden Messerelementen 212, 222 des Differentialpaares.

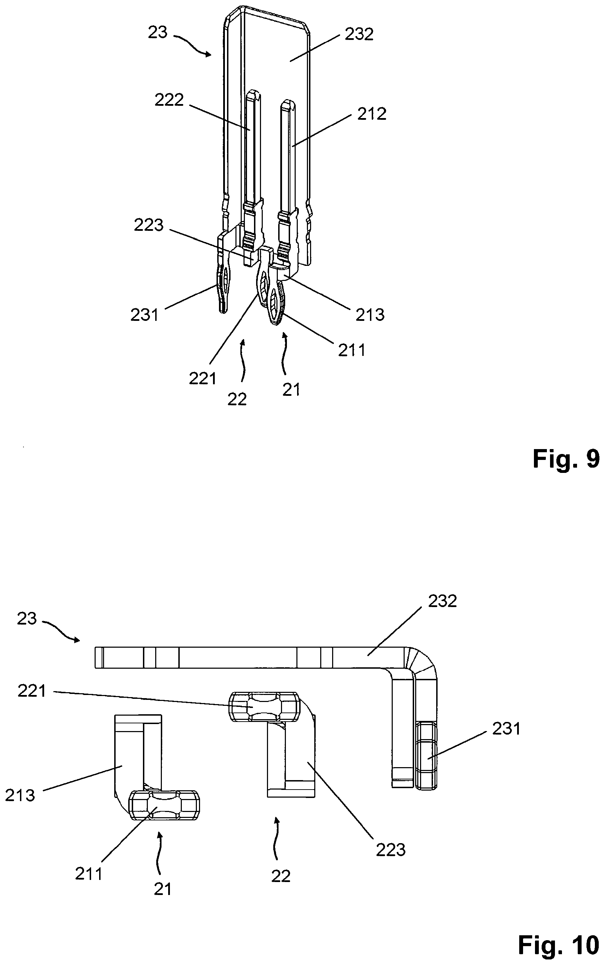

Eine isometrische Darstellung eines Differentialpaares aus zwei Signalkontakten 21, 22 und des dazugehörigen Abschirmkontaktes 13 ist in Fig. 9 dargestellt. Eine Ansicht eines Differentialpaares und dessen zugehörigem Abschirmkontakt 23 von unten, d. h. aus der Richtung der Signalkontaktelemente 211, 221 und des Abschirmkontaktelementes 231 findet sich in Fig. 10. Es ist zu erkennen, dass in jedem Signalkontakt 21, 22 das Messerelement 212, 221 und das Signalkontaktelement 211, 221 parallel zueinander angeordnet sind. Sie sind mit an einem Verbindungselement 213, 223 miteinander verbunden. Dieses ist im Wesentlichen stabförmig ausgebildet und bildet einen rechten Winkel sowohl mit dem Messerelement 212, 221 als auch mit dem Signalkontaktelement 211, 221. Hierdurch ist es möglich, die um 90° gedrehte erfindungsgemäße Anordnung der Messerelemente 212, 221 und Abschirmelemente 232 auf der Vorderseite des Steckverbinders sowie die Anordnung der Signalkontaktelemente 211, 212 und Abschirmkontaktelemente 231 auf der Rückseite des Steckverbinders zu realisieren.

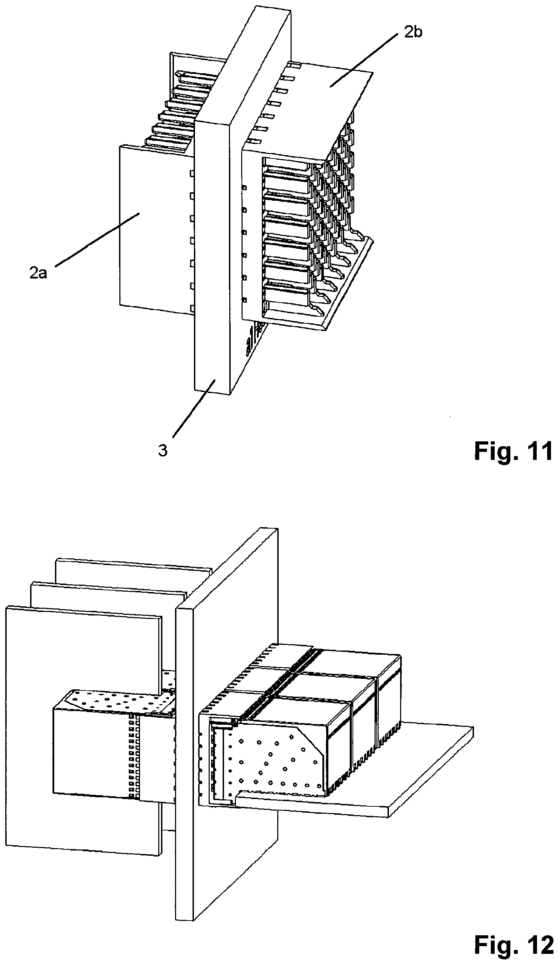

Eine Befestigung von zwei erfindungsgemäßen Steckverbindern 2a, 2b an einer Leiterplatte 3 ist in Fig. 11 dargestellt. Die Signalkontaktelemente 211, 221 und Abschirmkontaktelemente 231 des ersten Steckverbinders 2a sind auf einer Seite einer Leiterplatte 3 angeordnet und die Signalkontaktelemente 211, 221 und Abschirmkontaktelemente 231 des zweiten Steckverbinders 2b sind auf der anderen Seite der Leiterplatte 3 angeordnet. Hierbei sind die jeweils entsprechenden Signalkontaktelemente 211, 221 des ersten Steckverbinders 2a über die Leiterplatte 3 mit den korrespondierenden Signalkontaktelementen 211, 221 des zweiten Steckverbinders 2b verbunden. Der erste Steckverbinder 2a ist in einem Winkel von 90° zum zweiten Steckverbinder 2b gedreht (cross-connect). Die Leiterplatte 3 kann auf diese Weise als Backplane fungieren, um weitere Leiterplatten miteinander zu verbinden. So ist beispielsweise in Fig. 12 dargestellt, wie eine Leiterplatte 4a über drei Verbindungselemente mit drei erfindungsgemäßen Steckverbindern auf einer Seite einer Backplane 3 verbunden werden kann, wobei sich auf der gegenüberliegenden Seite der Backplane 3 drei weitere erfindungsgemäße Steckverbinder befinden, die jeweils mit einem Verbindungselement eine weitere Leiterplatte 4b, 4c, 4d kontaktieren, sodass die Leiterplatte 4a mit den drei gegenüber ihr um 90° gedrehten Leiterplatten 4b, 4c, 4d verbunden werden kann.

## Patentansprüche

1. Steckverbinder (2a, 2b) mit Abschirmung, der Signalkontakte (21, 22) aufweist, welche in einem Kontaktmuster von Differentialpaaren angeordnet sind und zusammen mit einem sie umgebenden Abschirmkontakt (23) eine Kontaktgruppe bilden, wobei
- jeder Signalkontakt (21, 22) ein Signalkontaktelement (211, 221) und ein Messerelement (212, 222) aufweist,
- jeder Abschirmkontakt (23) ein Abschirmelement (232) und mindestens ein Abschirmkontaktelement (231, 241a, 241b) aufweist,
- die Kontaktgruppen in Reihen (R₁ ... R₆) und Spalten (S₁ ... S14) angeordnet sind,
- alle Abschirmkontaktelemente (231, 241a, 241b) innerhalb einer Reihe (R₁ ... R₆) auf einer gemeinsamen Geraden (G1) liegen, und
- die Signalkontaktelemente (211, 221) jedes Differentialpaares jeweils auf einer Geraden (G3) liegen, die einen Winkel von 45° mit der gemeinsamen Geraden (G1) der Abschirmkontaktelemente (231, 241a, 241b) innerhalb der Reihe (R₁ ... R₆) bildet,
wobei in jeder Reihe (R₁ ... R₆) und in jeder Spalte (S₁ ... S₁₄) ein Abstand (a1) zwischen einem Mittelpunkt (M1) zwischen den beiden Signalkontaktelementen (211, 221) eines Differentialpaares und einem Mittelpunkt (M2) zwischen den Signalkontaktelementen (211, 221) eines benachbarten Differentialpaares einem Abstand (a2) zwischen zwei benachbarten Abschirmkontaktelementen (231, 241a, 241b) entspricht, und
wobei in jeder Spalte (S₁ ... S₁₄) ein Abschirmelement (242) C-förmig ausgeführt ist,
**dadurch gekennzeichnet, dass** alle weiteren Abschirmelemente (232) in dieser Spalte (S₁ ... S₁₄) L-förmig ausgeführt sind, und dass ein Abstand (a3) zwischen den beiden Signalkontaktelementen (211, 221) jedes Differentialpaares einem Abstand (a4) zwischen den beiden Messerelementen (212, 222) des Differentialpaares entspricht.

2. Steckverbinder (2a, 2b) nach Anspruch 1, **dadurch gekennzeichnet, dass**
- alle Abschirmkontaktelemente (231, 241a, 241b) innerhalb einer Spalte (S₁ ... S₁₄) auf einer gemeinsamen Geraden (G2) liegen, und
- die Signalkontaktelemente (211, 221) jedes Differentialpaares jeweils auf einer Geraden (G3) liegen, die einen Winkel von 45° mit der gemeinsamen Geraden (G2) der Abschirmkontaktelemente (231, 241a, 241b) innerhalb der Spalte (S₁ ... S₁₄) bildet.

3. Steckverbinder (2a, 2b) nach Anspruch 1 oder 2, **dadurch gekennzeichnet, dass** alle Messerelemente (212, 222) innerhalb einer Spalte (S₁ ... S₁₄) auf einer gemeinsamen Geraden (G4) liegen

4. Steckverbinder (2a, 2b) nach einem der Ansprüche 1 bis 3, **dadurch gekennzeichnet, dass** jeder Abschirmkontakt (23) mit L-förmigem Abschirmelement (232) ein Abschirmkontaktelement (231) aufweist und jeder Abschirmkontakt mit C-förmigem Abschirmelement (242) zwei Abschirmkontaktelemente (241a, 242b) aufweist.

5. Steckverbinder (2a, 2b) nach einem der Ansprüche 1 bis 4, **dadurch gekennzeichnet, dass** das Signalkontaktelement (211, 221) und das Messerelement (212, 222) jedes Signalkontakts (21, 22) parallel zueinander angeordnet sind, und mit einem Verbindungselement (213, 223) miteinander verbunden sind.

6. Anordnung umfassend zwei Steckverbinder (2a, 2b) nach einem der Ansprüche 1 bis 5, wobei die Signalkontaktelemente (211, 221) und Abschirmkontaktelemente (231, 241a, 241b) des ersten Steckverbinders (2a) auf einer Seite einer Leiterplatte (3) angeordnet sind und die Signalkontaktelemente (211, 221) und Abschirmkontaktelemente (231, 241a, 241b) des zweiten Steckverbinders (2b) auf der anderen Seite der Leiterplatte (3) angeordnet sind, wobei die Signalkontaktelemente (211, 221) des ersten Steckverbinders (2a) mit den Signalkontaktelemente (211, 221) des zweiten Steckverbinders (2b) verbunden sind, und der erste Steckverbinder (2a) in einem Winkel von 90° zu dem zweiten Steckverbinder (2b) gedreht ist.

## Claims

1. A plug connector (2a, 2b) with shielding, comprising signal contacts (21, 22) which are arranged in a contact pattern of differential pairs and form a contact group together with a shielding contact (23) which surrounds them, wherein
- each signal contact (21, 22) comprises a signal contact element (211, 221) and a blade element (212, 222);
- each shielding contact (23) comprises a shielding element (232) and at least one shielding contact element (231, 241a, 241b);
- the contact groups are arranged in rows (R1 ... R6) and columns (S1 ... S14);
- all shielding contact elements (231, 241a, 241b) lie within a row (R1 ... R6) on a common straight line (G1), and
- the signal contact elements (211, 221) of each differential pair respectively lie on a straight line (G3) which forms an angle of 45° with the common straight line (G1) of the shielding contact elements (231, 241a, 241b) within the row (R1 ... R6),
wherein in each row (R₁ ... R₆) and in each column (S₁ ... S₁₄), a distance (a1) between the centre point (M1) of the two signal contact elements (211, 221) of a differential pair and the centre point (M2) of the signal contact elements (211, 221) of an adjacent differential pair correspond to a distance (a2) between two adjacent shielding contact elements (231, 241a, 241b), and
wherein one shielding element (242) is arranged in a C-shaped manner in each column (S₁ ... S₁₄)
**characterized in that** all further shielding elements (232) in said column (S₁ ... S₁₄) are arranged in an L-shaped manner,
and that a distance (a3) between the two signal contact elements (211, 221) of each differential pair corresponds to a distance (a4) between the two blade elements (212, 222) of the differential pair.

2. A plug connector (2a, 2b) according to claim 1, **characterized in that**
- all shielding contact elements (231, 241a, 241b) within a column (S1 ... S14) lie on a common straight line (G2), and
- the signal contact elements (211, 221) of each differential pair respectively lie on a straight line (G3) which forms an angle of 45° with the common straight line (G2) of the shielding contact elements (231, 241a, 241b) within the column (S1 ... S14).

3. A plug connector (2a, 2b) according to claim 1 or 2, **characterized in that** all blade elements (212, 222) within a column (S₁ ... S₁₄) lie on a common straight line (G4).

4. A plug connector (2a, 2b) according to one of the claims 1 to 3, **characterized in that** each shielding contact (23) with L-shaped shielding element (232) comprises a shielding contact element (231) and each shielding contact with C-shaped shielding element (242) comprises two shielding contact elements (241a, 242b).

5. A plug connector (2a, 2b) according to one of the claims 1 to 4, **characterized in that** the signal contact element (211, 221) and the blade element (212, 222) of each signal element (21, 22) are arranged in parallel with respect to each other and are connected to each other by a connecting element (213, 223).

6. An arrangement comprising two plug connectors (2a, 2b) according to one of the claims 1 to 5, wherein the signal contact elements (211, 221) and shielding contact elements (231, 241a, 241b) of the first connector (2a) are arranged on one side of the circuit board (3) and the signal contact elements (211, 221) and shielding contact elements (231, 241a, 241b) of the second connector (2b) are arranged on the other side of the circuit board (3), wherein the signal contact elements (211, 221) of the first plug connector (2a) are connected to the signal contact elements (211, 221) of the second plug connector (2b), and the first plug connector (2a) is twisted at an angle of 90° in relation to the second plug connector (2b).

## Revendications

1. Connecteur (2a, 2b) à blindage, comportant des contacts de signal (21, 22) agencés selon une configuration de contact par paires différentielles et formant un groupe de contacts conjointement avec un contact de blindage (23) entourant celles-ci, dans lequel
- chaque contact de signal (21, 22) comporte un élément de contact de signal (211, 221) et un élément à couteau (212, 222),
- chaque contact de blindage (23) comporte un élément de blindage (232) et au moins un élément de contact de blindage (231, 241a, 241b),
- les groupes de contacts sont disposés en rangées (R₁... R₆) et en colonnes (S₁... S₁₄),
- tous les éléments de contact de blindage (231, 241a, 241b) dans une rangée (Ri... R₆) se situent sur une ligne droite commune (G1), et
- les éléments de contact de signal (211, 221) de chaque paire différentielle se situent respectivement sur une ligne droite (G3) qui forme un angle de 45° avec la ligne droite commune (G1) des éléments de contact de blindage (231, 241a, 241b) dans la rangée (R₁ ... R₆),
et dans lequel, dans chaque rangée (R₁ ... R₆) et dans chaque colonne (S₁... S₁₄), un écart (a1) entre un point central (M1) situé entre les deux éléments de contact de signal (211, 221) d'une paire différentielle et un point central (M2) situé entre les éléments de contact de signal (211, 221) d'une paire différentielle adjacente correspond à un écart (a2) entre deux éléments de contact de blindage (231, 241a, 241b) adjacents, et
dans chaque colonne (S₁... S₁₄), un élément de blindage (242) est configuré en forme de C;
**caractérisé en ce que** tous les autres éléments de blindage (232) dans cette colonne (S₁... S₁₄) sont configurés en forme de L
et qu'un écart (a3) entre les deux éléments de contact de signal (211, 221) de chaque paire différentielle correspond à un écart (a4) entre les deux éléments à couteau (212, 222) de la paire différentielle.

2. Connecteur (2a, 2b) selon la revendication 1, **caractérisé en ce que**
- tous les éléments de contact de blindage (231, 241a, 241b) dans une colonne (S₁ ... S₁₄) se situent sur une ligne droite commune (G2), et
- les éléments de contact de signal (211, 221) de chaque paire différentielle se situent respectivement sur une ligne droite (G3), qui forme un angle de 45° avec la ligne droite commune (G2) des éléments de contact de blindage (231, 241a, 241b) dans la colonne (S₁... S₁₄).

3. Connecteur (2a, 2b) selon la revendication 1 ou 2, **caractérisé en ce que** tous les éléments à couteau (212, 222) dans une colonne (S₁... S₁₄) se situent sur une ligne droite commune (G4).

4. Connecteur (2a, 2b) selon l'une des revendications 1 à 3, **caractérisé en ce que** chaque contact de blindage (23) à élément de blindage (232) en forme de L comporte un élément de contact de blindage (231) et chaque contact de blindage à élément de blindage (242) en forme de C comporte deux éléments de contact de blindage (241a, 242b).

5. Connecteur (2a, 2b) selon l'une des revendications 1 à 4, **caractérisé en ce que** l'élément de contact de signal (211, 221) et l'élément à couteau (212, 222) de chaque contact de signal (21, 22) sont disposés parallèlement l'un à l'autre et sont reliés entre eux par un élément de liaison (213, 223).

6. Dispositif comprenant deux connecteurs (2a, 2b) selon l'une des revendications 1 à 5, dans lequel les éléments de contact de signal (211, 221) et les éléments de contact de blindage (231, 241a, 241b) du premier connecteur (2a) sont disposés sur une face d'une carte à circuit imprimé (3), et les éléments de contact de signal (211, 221) et les éléments de contact de blindage (231, 241a, 241b) du deuxième connecteur (2b) sont disposés sur l'autre face de la carte à circuit imprimé (3) ; les éléments de contact de signal (211, 221) du premier connecteur (2a) étant reliés aux éléments de contact de signal (211, 221) du deuxième connecteur (2b), et le premier connecteur (2a) étant pivoté de 90° par rapport au deuxième connecteur (2b).
